# EUROPEAN PATENT APPLICATION

(11) **EP 4 757 573 A1**
(43) Date of publication of application: **10.06.2026**
(21) Application number: 25217260.6
(22) Date of filing: 20.11.2025
(51) Int. Cl.: H10W 70/63, H10W 70/68, H10W 70/692

(54) **SEMICONDUCTOR DEVICE WITH EMBEDDED DIE AND METHOD THEREFOR**

(30) Priority: 09.12.2024 US 202418973268
(71) Applicant: NXP B.V., 5656 AG Eindhoven (NL)
(72) Inventor: Lo, Tsung Nan, 5656AG Eindhoven (NL); Huang, Wen Hung, 5656AG Eindhoven (NL); Chuang, Wen Yuan, 5656AG Eindhoven (NL); Eu, Poh Leng, 5656AG Eindhoven (NL)
(74) Representative: Colaiuda, Antonella

(57) **Abstract**

A method of forming a semiconductor device with an embedded die is provided. The method includes forming a cavity at a first major side of a glass substrate. A reduced thickness portion of the glass substrate remaining between a bottom of the first cavity and a second major side of the glass substrate. A plurality of first through glass vias (TGV) and a plurality of second TGV are formed through the reduced thickness portion of the glass substrate. The glass substrate is placed over a semiconductor die having a plurality of copper pillars formed on respective bond pads. The semiconductor die is positioned within the first cavity such that the plurality of copper pillars extend through respective first TGV. A bonding material is injected into the cavity such that space remaining between the glass substrate and the semiconductor die is substantially filled.

## Description

### Background

### Field

This disclosure relates generally to semiconductor device packaging, and more specifically, to a semiconductor device with embedded die and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. With such features and applications, the configuration of the semiconductor device packages may limit performance of the semiconductor devices or impact the costs of the semiconductor devices. Accordingly, significant challenges exist in accommodating these features and applications while minimizing the impact on semiconductor devices' performance and costs.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified plan view, an example semiconductor device with embedded die at a stage of manufacture in accordance with an embodiment.
FIG. 2 through FIG. 9 illustrate, in simplified cross-sectional views, the example semiconductor device taken along line A-A of FIG. 1 at various stages of manufacture in accordance with an embodiment.
FIG. 10 through FIG. 14 illustrate, in simplified cross-sectional views, an alternative example semiconductor device with embedded die taken along line A-A of FIG. 1 at various stages of manufacture in accordance with an embodiment.

### Detailed Description

Generally, there is provided, a semiconductor device with an embedded semiconductor die. The semiconductor device includes a glass substrate configured as a package body. The glass substrate includes a cavity formed at a first major side and a plurality of through-glass vias. The semiconductor die includes copper pillars formed on bond pads. The semiconductor die is embedded in the cavity and the copper pillars are inserted through the through-glass vias. A bonding material is injected into the cavity to fill gaps between the semiconductor die and inner surfaces of the cavity. A redistribution structure is applied over a second major side of the glass substrate and interconnected with the copper pillars exposed through the through-glass vias. By forming the semiconductor device with an embedded semiconductor die in this manner, a substantially rigid and low-profile semiconductor device with improved heat dissipation may be realized.

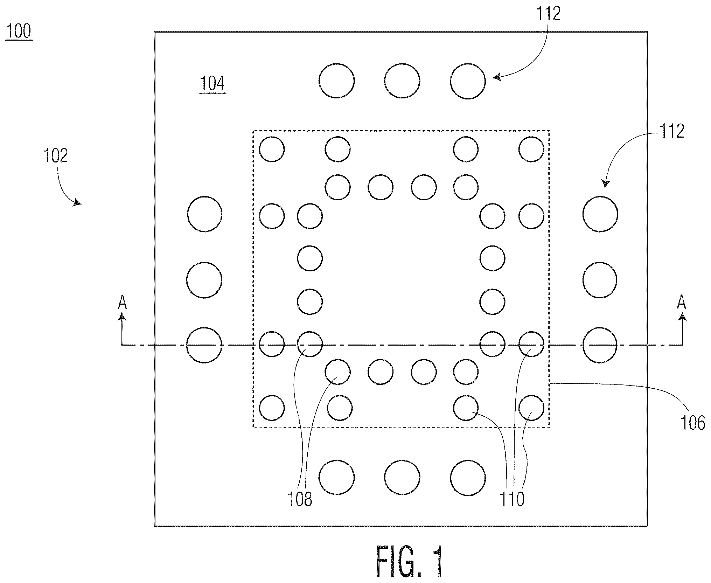

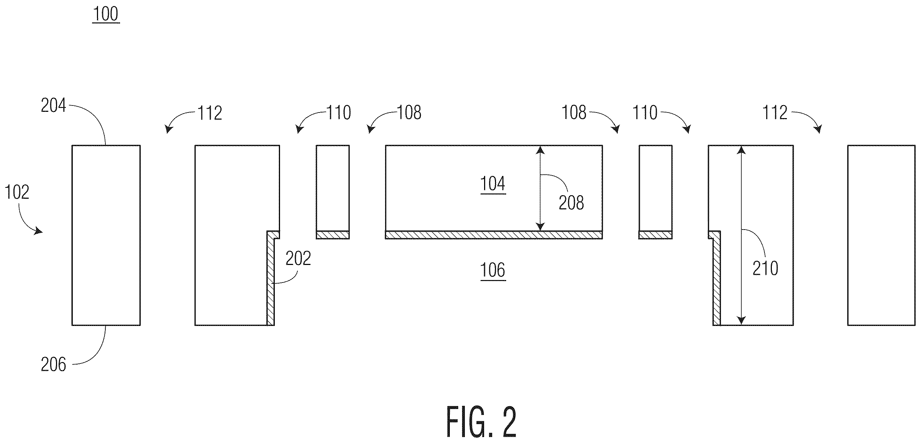

FIG. 1 illustrates, in a simplified bottom-side-up plan view, an example semiconductor device 100 having an embedded die in accordance with an embodiment. At this stage, the semiconductor device 100 includes a glass substrate 104, a cavity 106 formed at a top side of the glass substrate (shown as dashed outline for reference), a first plurality of through-glass vias (TGV) 108, a second plurality of TGV 110, and a third plurality of TGV 112. The glass substrate 104 may be provided in a wafer or panel form and may be formed from a suitable glass material such as borosilicate, soda-lime, or fused silica, for example. In this embodiment, the glass substrate 104, cavity 106, and TGV 108, 110, 112 together are configured to form a package body 102. The size, shape, and location of the cavity 106 and TGV 108, 110, 112 depicted in FIG. 1 are chosen for illustration purposes. Cross-sectional views of examples of the semiconductor device 100 taken along line A-A of FIG. 1 at various stages of manufacture are depicted in FIG. 2 through FIG. 9.

FIG. 2 illustrates, in a simplified bottom-side-up cross-sectional view, the example semiconductor device 100 at the stage of manufacture depicted in FIG. 1 in accordance with an embodiment. At this stage, the package body 102 of the semiconductor device 100 includes the glass substrate 104, the cavity 106 formed at the top major side 206 of the glass substrate, the first plurality of TGV 108, the second plurality of TGV 110, and the third plurality of TGV 112. In this embodiment, the cavity 106 of the package body 102 further includes a conductive (e.g., metal) lining 202 formed on sidewall and bottom surfaces. It may be desirable to form the metal lining 202 on the sidewall and bottom surfaces (e.g., by way of sputtering and/or plating) before forming the TGV 108 and 110. The term "conductive," as used herein, generally refers to electrical conductivity unless otherwise described.

In this embodiment, the cavity 106 is formed to a predetermined depth at the top side 206 of the glass substrate 104 such that a reduced-thickness portion 208 of the glass substrate 104 remains between a bottom surface of the cavity 106 and the bottom major side 204 of the glass substrate. The cavity 106 may be formed by way of laser drilling or other suitable methods. The cavity 106 is configured having a size and shape sufficient to at least partially embed a semiconductor die within the glass substrate 104, for example, at a subsequent stage of manufacture. In this embodiment, a full-thickness portion 210 of the glass substrate 104 extends from the bottom side 204 of the glass substrate 104 to the top side 206 of the glass substrate (as depicted in FIG. 2) and substantially surrounds the cavity 106.

The pluralities of TGV 108 and 110 are formed as vertical openings through the reduced-thickness portion 208 of the glass substrate 104. The TGV 108 and 110 may be formed by way of laser drilling, for example. Each of the TGV 108 and 110 extends from the bottom side 204 of the glass substrate 104 to the bottom of the cavity 106 formed in the glass substrate as depicted in FIG. 2. In this embodiment, each of the TGV 108 of the plurality is configured having a size and shape sufficient for insertion of a copper pillar through the reduced-thickness portion 208 of the glass substrate 104. For example, the diameter of the TGV 108 is configured wider than the diameter of the copper pillar such that a predetermined gap remains between the copper pillar and the sidewalls of the TGV 108. formed on semiconductor die within the glass substrate 104, for example, at a subsequent stage of manufacture. In this embodiment, each of the TGV 110 of the plurality is configured having a size and shape sufficient for injecting a bonding material into the cavity 106 by way of TGV 110 (e.g., at a subsequent stage of manufacture).

The plurality of TGV 112 is formed as vertical openings through the full-thickness portion 210 of the glass substrate 104. The TGV 112 may be formed by way of laser drilling, for example. Each of the TGV 112 extends from the bottom side 204 of the glass substrate 104 to the top side 206 the glass substrate as depicted in FIG. 2. In this embodiment, each of the TGV 112 of the plurality is configured having a size and shape sufficient for a conductive via (e.g., at a subsequent stage of manufacture).

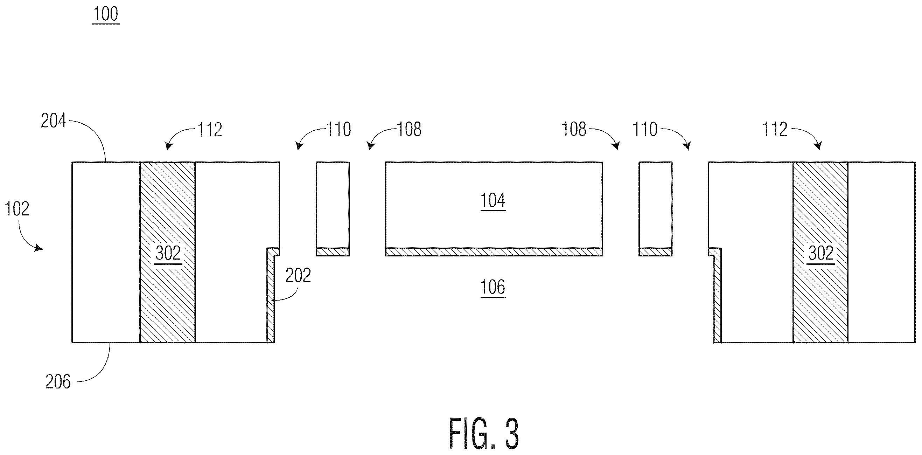

FIG. 3 illustrates, in a simplified bottom-side-up cross-sectional view, the example semiconductor device 100 at a subsequent stage of manufacture in accordance with an embodiment. At this stage, the package body 102 of the semiconductor device 100 includes conductive vias 302 formed in respective TGV 112 of the glass substrate 104. Each of the conductive vias 302 are configured to form a conductive interconnect through the full-thickness portion 210 of the glass substrate 104. In this embodiment, the conductive vias 302 may be formed by way of electroplating a conductive (e.g., copper) material in the TGV 112 openings through the full-thickness portion 210 (FIG. 2) of the glass substrate 104. For example, the conductive material may be electroplated to form a metal lining on sidewalls of the TGV 112. In some embodiments, a conductive material may be deposited or otherwise dispensed into the TGV 112 to form a substantially solid (e.g., non-hollow) conductive interconnect through the full-thickness portion 210 of the glass substrate 104.

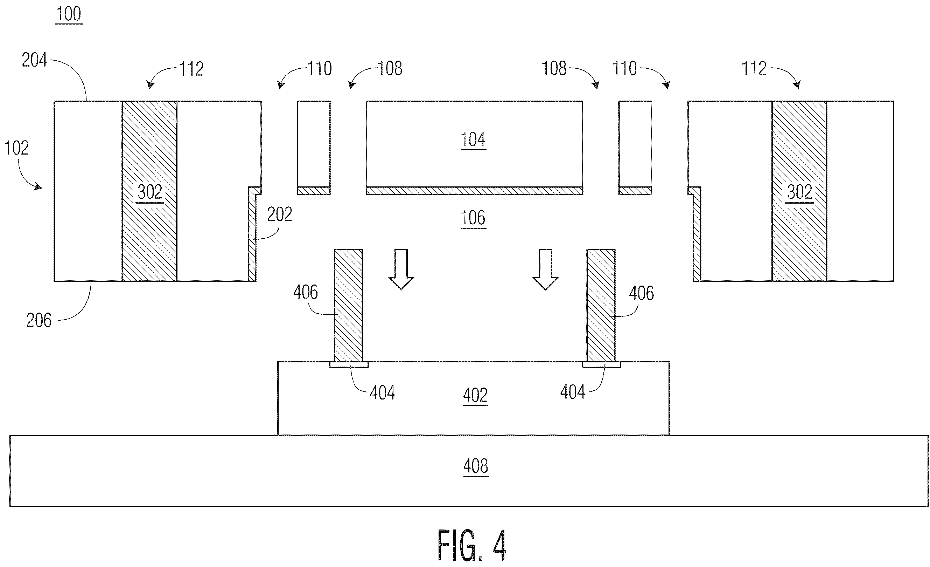

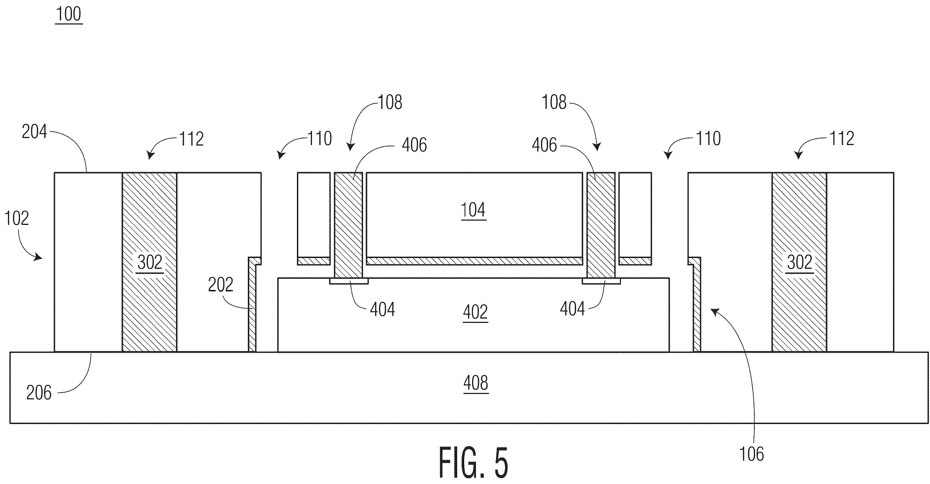

FIG. 4 and FIG. 5 illustrate, in simplified bottom-side-up cross-sectional views, the example semiconductor device 100 at a subsequent stage of manufacture in accordance with an embodiment. At this stage, a semiconductor die 402 is placed on a carrier substrate 408 and the package body 102 is positioned and aligned over the semiconductor die. The semiconductor die 402 is temporarily affixed to the carrier substrate 408 by way of a releasable adhesive (not shown) at a top side of the carrier substrate, for example.

The semiconductor die 402 has an active side (e.g., major side having circuitry) and a backside (e.g., major side opposite of the active side). The semiconductor die 402 includes die pads 404 formed at the active side and connected to circuitry of the semiconductor die. In this embodiment, the backside of the semiconductor die adhered to the carrier substrate 408. The semiconductor die 402 may be formed from any suitable semiconductor material, such as silicon, germanium, gallium arsenide, gallium nitride, and the like. The semiconductor die 402 may further include RF circuits, digital circuits, analog circuits, power circuits, memories, processors, the like, and combinations thereof at the active side. In this embodiment, copper pillars 406 are formed directly over respective die pads 404 of the semiconductor die 402.

After the semiconductor die 402 is placed on the carrier substrate 408, the package body 102 is lowered over the semiconductor die 402 until the full-thickness portion 210 (FIG. 2) of the glass substrate 104 is temporarily affixed to the carrier substrate 408 by way of the releasable adhesive. As the package body 102 is lowered onto the carrier substrate 408, the semiconductor die 402 is inserted into the cavity 106 and concurrently the copper pillars 408 are inserted into respective TGV 108. With top side 206 of the package body 102 temporarily affixed to the carrier substrate 408, the semiconductor die 402 is disposed within the cavity 106 and the copper pillars 406 are disposed within the respective TGV 108 as depicted in FIG. 5. Accordingly, the backside of the semiconductor die 402 is substantially coplanar with the top side 206 of the full-thickness portion 210 of the glass substrate 104 surrounding the cavity 106. Likewise, the distal ends of the copper pillars extending through the TGV 108 are substantially coplanar with the bottom side 204 of the glass substrate 104. Further, an air gap is formed between the semiconductor die 402 and the sidewalls and bottom surface of the cavity 106 and an air gap is formed between the copper pillars 406 and the TGV 108.

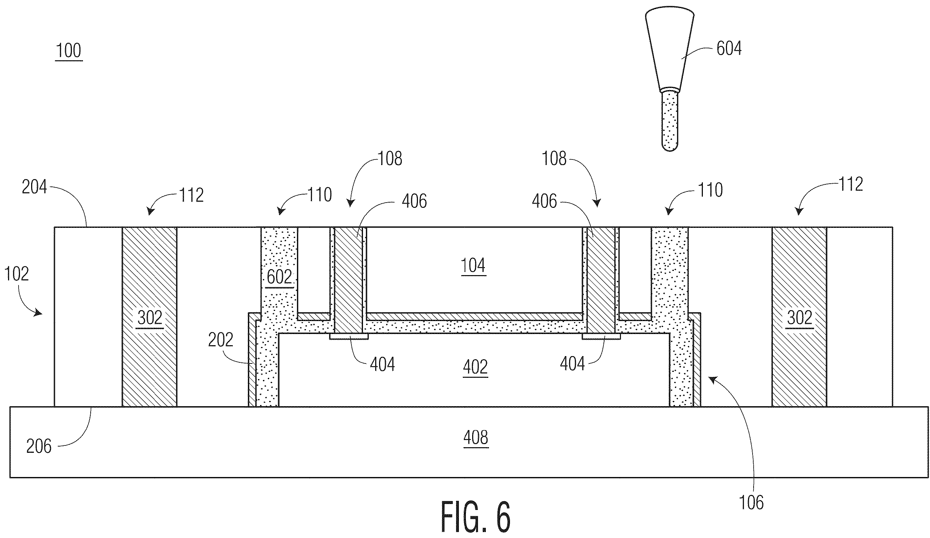

FIG. 6 illustrates, in a simplified bottom-side-up cross-sectional view, the example semiconductor device 100 at a subsequent stage of manufacture in accordance with an embodiment. At this stage, a bonding material 602 substantially fills the air gaps between the semiconductor die 402 and the sidewalls and bottom surface of the cavity 106 and between the copper pillars 406 and the TGV 108. In this embodiment, the bonding material 602 is injected or otherwise dispensed into the cavity 106 by way of the TGV110 while the package body 102 and the semiconductor die 402 are temporarily affixed to the carrier substrate 408. The bonding material 602 may be a suitable non-conductive material such as underfill epoxy, die attach epoxy, polyimide, polyphenylene benzobisoxazole (PBO), and the like. The TGV 110 serve as ports though the reduced-thickness portion 208 (FIG. 2) of the glass substrate 104 and to the cavity 106. For example, the TGV 110 provide a pass-thru for injection apparatus 604 to inject the bonding material 602 into the cavity 106 as well as allowing air within the cavity to escape as the bonding material fills the cavity.

In this embodiment, the air gaps formed between the semiconductor die 402 and the sidewalls and bottom surface of the cavity 106 and between the copper pillars 406 and the TGV 108 are substantially filled with the bonding material 602 during an injection operation using the injection apparatus 604. After the injection operation, a bonding material residue may remain at the bottom side 204. A subsequent grind or clean operation may be employed to planarize and/or remove the bonding material residue to ensure that the distal ends of the copper pillars 406 are exposed (i.e., not covered with the bonding material). In this embodiment, the bonding material 602 serves as a bonding material configured to bond the semiconductor die and copper pillars with the package body 102. With the bonding material 602 cured, a substantially rigid hermetic seal is formed between the semiconductor die 402 and the package body 102 and between the copper pillars 406 and the package body 102.

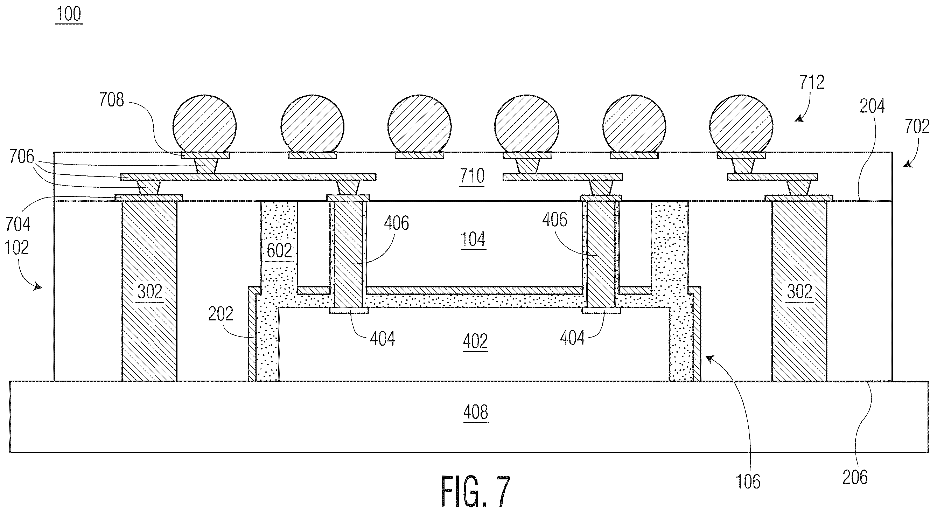

FIG. 7 illustrates, in a simplified bottom-side-up cross-sectional view, the example semiconductor device 100 at a subsequent stage of manufacture in accordance with an embodiment. At this stage, the semiconductor device 100 includes a redistribution structure 702 applied over the bottom side 204 of the package body 102. In this embodiment, the redistribution structure 702 is formed as a build-up package substrate. In some embodiments, the redistribution structure 702 may be provided as a preformed package substrate. The redistribution structure 702 (also referred to herein as "package substrate") includes conductive features (e.g., patterned copper traces and vias 704, 706, 708) substantially embedded in a non-conductive substrate material (e.g., dielectric 710). The redistribution structure 702 includes portions of traces 704 conductively connected to the conductive vias 302 and the copper pillars 406 at the bottom side 204 of the package body 102 and portions of traces 708 conductively connected to a plurality of conductive package connectors 712 (e.g., solder balls) at the bottom side of the redistribution structure. The conductive package connectors 712 are configured and arranged to provide conductive connections between the redistribution structure 702 and a PCB, for example. The conductive package connectors 712 may be in the form of suitable conductive structures such as solder balls, gold studs, copper pillars, and the like, configured to connect conductive features of the semiconductor device 100 with the PCB.

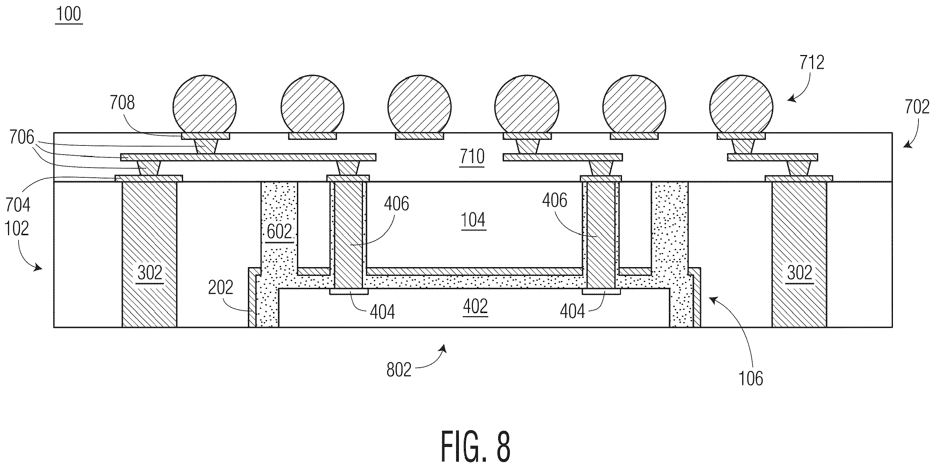

FIG. 8 illustrates, in a simplified bottom-side-up cross-sectional view, the example semiconductor device 100 at a subsequent stage of manufacture in accordance with an embodiment. At this stage, the semiconductor device 100 is separated from the carrier substrate 408 (FIG. 7) and thinned from the top side. After separating the semiconductor device 100 from the carrier substrate, the top side 802 of the semiconductor device 100 is subjected to a grind operation to significantly reduce the package body 102 and semiconductor die 402 thickness. For example, it may be desirable to reduce the thickness of the semiconductor die 402 to 50 microns or less for improved heat dissipation. After the grind operation, the backside of the semiconductor die 402 and the top side of the glass substrate 104 remain substantially coplanar. By significantly reducing the package body 102 and semiconductor die 402 thickness in this manner, a substantially rigid and low-profile semiconductor device 100 with improved heat dissipation may be realized.

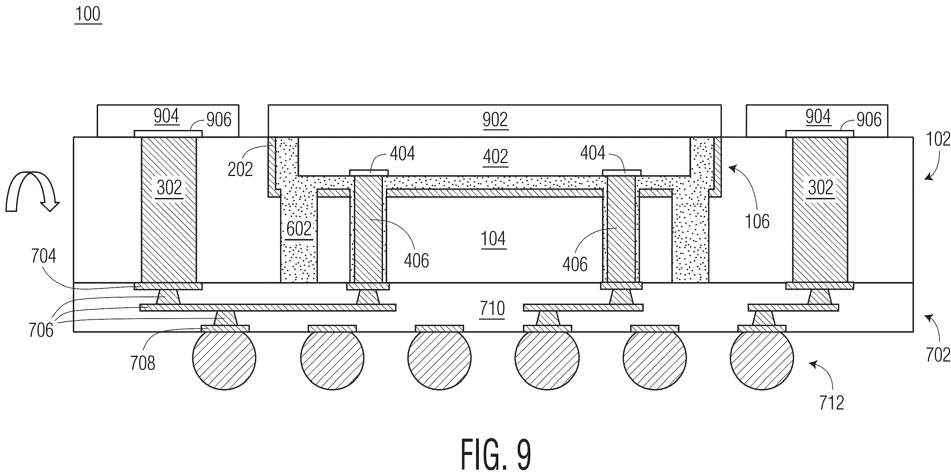

FIG. 9 illustrates, in a simplified top-side-up cross-sectional view, the example semiconductor device 100 at a subsequent stage of manufacture in accordance with an embodiment. At this stage, a heat sink 902 and external components 904 are attached at the top side of the semiconductor device 100. The semiconductor device 100 is reoriented (e.g., flipped) and configured for attachment of the heat sink 902 and external components 904. In this embodiment, the heat sink 902 is configured for thermal dissipation. The heat sink 902 may be formed from a metal material (e.g., copper, aluminum) and attached to the backside of the semiconductor die 402 by way of a thermally and electrically conductive material (not shown), for example. In this embodiment, the heat sink may be further connected to the metal lining 202 formed on sidewall and bottom surfaces of the cavity 106. The heat sink 902 together with the metal lining may be configured to serve as an electromagnetic interference (EMI) shield.

In this embodiment, the external components 904 include connection pads 906 which are connected to the conductive vias 302 by way of a conductive interface material such as solder, solder paste, or conductive adhesive (not shown). The external components 904 as depicted in FIG. 9 are chosen for illustration purposes. Each of the external components 904 may be any of a semiconductor die, an active element (e.g., transistor, diode), a passive element (e.g., resistor, capacitor, inductor), an antenna, combinations thereof, and the like.

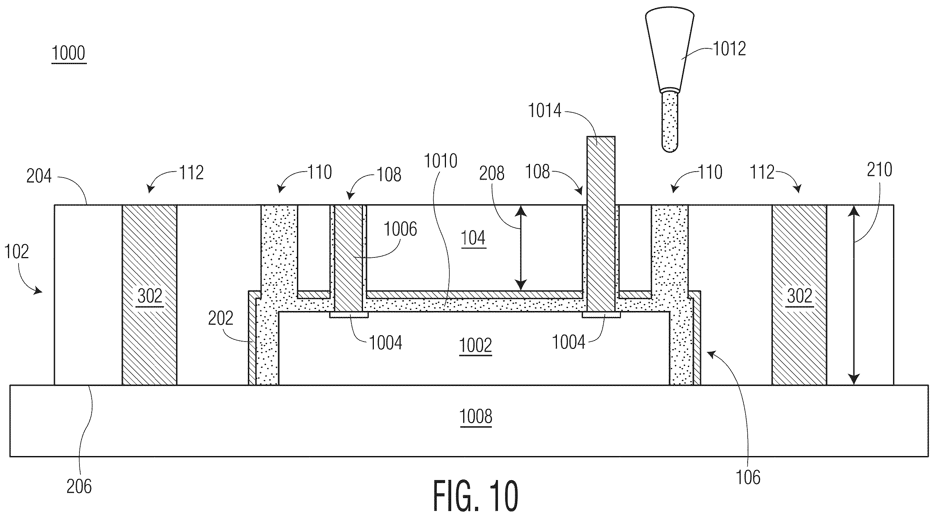

FIG. 10 through FIG. 14 illustrate, in simplified cross-sectional views, an alternative example semiconductor device 1000 having an embedded die at stages of manufacture in accordance with an embodiment. The stages of manufacture depicted in FIG. 10 through FIG. 14 are an alternative to the stages of manufacture for the example semiconductor device 100 depicted in FIG. 4 through FIG. 9, with stages of manufacture depicted in FIG. 1 through FIG. 3 (e.g., forming package body 102) remaining substantially the same.

FIG. 10 illustrates, in a simplified cross-sectional view, the example semiconductor device 1000 at a stage of manufacture in accordance with an embodiment. At this stage, a semiconductor die 1002 is placed on a carrier substrate 1008 and the package body 102 is placed over the semiconductor die 1002 and onto the carrier substrate 1008. The semiconductor die 1002 and the package body 102 are temporarily affixed to the carrier substrate 1008 by way of a releasable adhesive (not shown) at a first side of the carrier substrate, for example.

The semiconductor die 1002 has an active side (e.g., major side having circuitry) and a backside (e.g., major side opposite of the active side). The semiconductor die 1002 includes die pads 1004 formed at the active side and connected to circuitry of the semiconductor die. In this embodiment, the backside of the semiconductor die adhered to the carrier substrate 1008. The semiconductor die 1002 may be formed from any suitable semiconductor material, such as silicon, germanium, gallium arsenide, gallium nitride, and the like. The semiconductor die 1002 may further include RF circuits, digital circuits, analog circuits, power circuits, memories, processors, the like, and combinations thereof at the active side. In this embodiment, copper pillars 1006 and 1014 are formed directly over respective die pads 1004 of the semiconductor die 1002.

After the semiconductor die 1002 is placed on the carrier substrate 1008, the package body 102 is placed over the semiconductor die 1002 such that the full-thickness portion 210 of the glass substrate 104 is temporarily affixed to the carrier substrate 1008 by way of the releasable adhesive. As the package body 102 is placed onto the carrier substrate 1008, the semiconductor die 1002 is inserted into the cavity 106 and concurrently the copper pillars 1006 and 1014 are inserted into respective TGV 108. In this embodiment, the copper pillar 1014 is taller than the copper pillar 1006. For example, with the package body 102 and the semiconductor die 1002 affixed to the carrier substrate 1008, the distal end of the copper pillar 1006 is substantially coplanar with a first major side 204 of the glass substrate 104 while the copper pillar extends through the glass substrate 104 and protrudes above the first major side.

In this embodiment, a bonding material 1010 substantially fills the gaps between the semiconductor die 1002 and the sidewalls and bottom surface of the cavity 106 and between the copper pillars 1006, 1014 and the TGV 108. The bonding material 1010 is injected into the cavity 106 by way of the TGV110 during an injection operation using injection apparatus 1012, for example. In this embodiment, the bonding material 1010 serves as a bonding material configured to bond the semiconductor die 1002 and copper pillars 1006, 1014 with the package body 102.

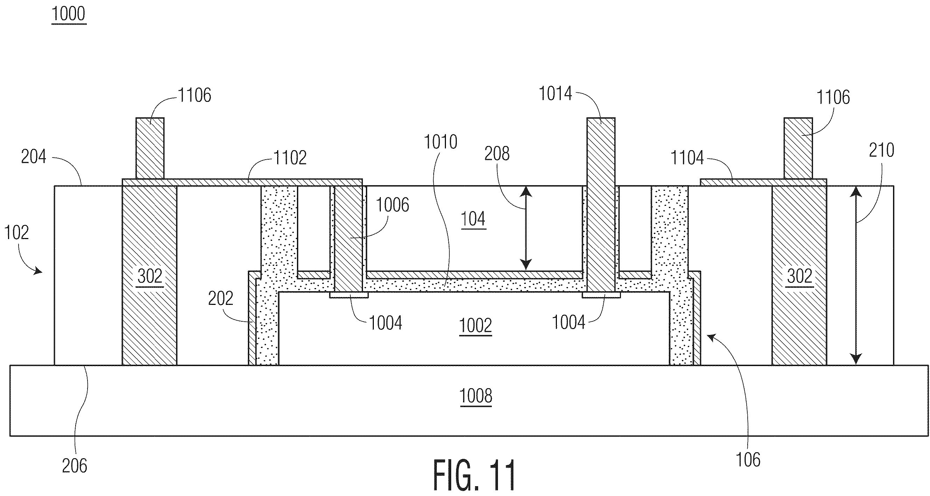

FIG. 11 illustrates, in a simplified cross-sectional view, the example semiconductor device 1000 at a subsequent stage of manufacture in accordance with an embodiment. At this stage, redistribution structures are formed at the first major side 204 of the glass substrate 104. In this embodiment, redistribution traces 1102 and 1104 are formed on the first major side 204 and interconnected with respective conductive vias 302. For example, the coper pillar 1006 connected to the bond pad 1004 of the semiconductor die 1002 is interconnected with the conductive via 302 by way of the trace 1102. In this embodiment, traces 1102 and 1104 may be characterized as patterned copper traces of a redistribution layer.

After the redistribution traces 1102 and 1104 are formed on the first major side 204, copper pillars 1106 are formed on respective redistribution traces 1102 and 1104. In this embodiment, copper pillars 1106 are formed on respective redistribution traces 1102 and 1104 and directly over respective conductive vias 302 of the package body 102. The copper pillars 1106 are formed to a predetermined height such that distal ends of the copper pillars 1106 are substantially coplanar with the distal end of the copper pillar 1014 in this embodiment.

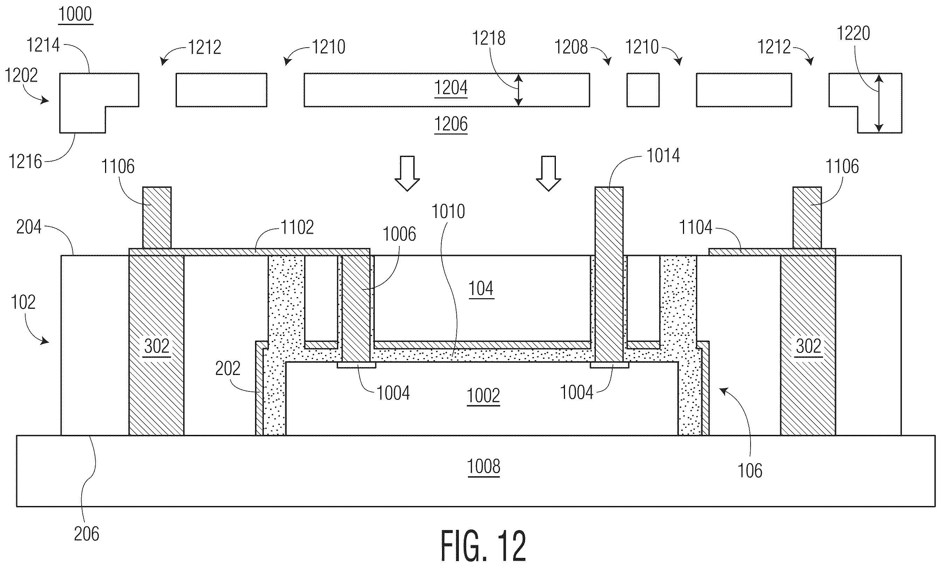

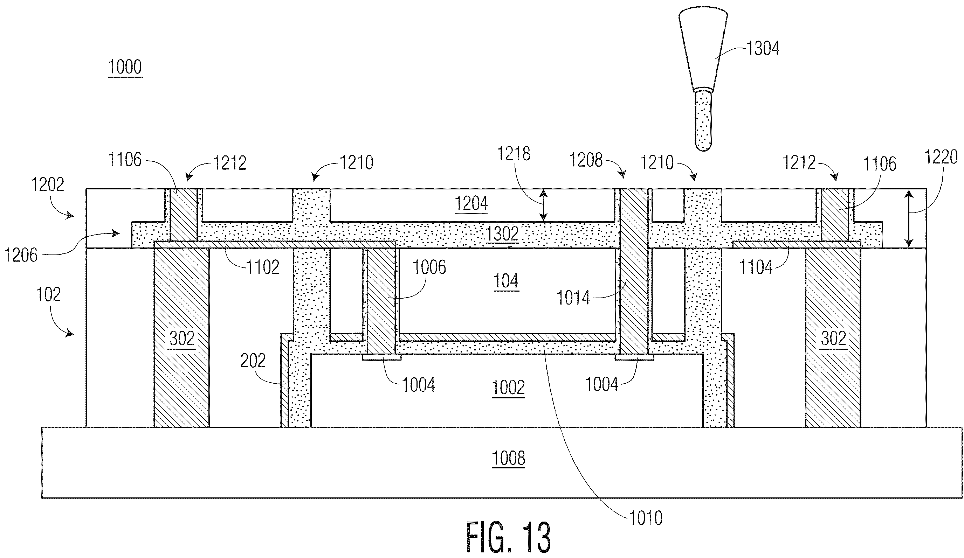

FIG. 12 and FIG. 13 illustrate, in simplified cross-sectional views, the semiconductor device 1000 at a subsequent stage of manufacture in accordance with an embodiment. At this stage, a package cap 1202 is positioned and aligned over the first major side 204 of the package body 102 then affixed to the package body.

In this embodiment, the package cap 1202 is formed from a second glass substrate 1204 having a first major side 1214 and a second major side 1216. The package cap 1202 includes a cavity 1206 formed to a predetermined depth at the second major side 1216 of the glass substrate 1204. A reduced-thickness portion 1218 of the glass substrate 1204 remains between a bottom surface of the cavity 1206 and the first major side 1214 of the glass substrate. The cavity 1206 is configured having a size and shape sufficient to embed the redistribution traces 1102 and 1104 within the glass substrate 1204, for example. In this embodiment, a full-thickness portion 1220 of the glass substrate 1204 extends from the first major side 1214 of the glass substrate 1204 to the second major side 1216 of the glass substrate and substantially surrounds the cavity 1206.

TGV 1208, 1210 and 1212 are formed as vertical openings through the reduced-thickness portion 1218 of the glass substrate 1204. Each of the TGV 1208, 1210 and 1212 extends from the first major side 1214 of the glass substrate 1204 to the bottom of the cavity 1206 formed in the second major side 1216. In this embodiment, each of the TGV 1208 and 1212 is configured having a size and shape sufficient for insertion of a copper pillar through the reduced-thickness portion 1218 of the glass substrate 1204. For example, the diameters of the TGV 1208 and 1212 are configured wider than the diameter of the respective copper pillars 1014 and 1106 such that a predetermined gap remains between the copper pillars and the sidewalls of the TGV 1208. In this embodiment, each of the TGV 1210 is configured having a size and shape sufficient for injecting a bonding material into the cavity 1206.

As the package cap 1202 is lowered onto the first major side 204 of the package body 102, the copper pillars 1014 and 1106 are inserted into respective TGV 1208 and 1212. With the package cap 1202 affixed to the first major side 204 of the package body 102, the distal ends of the copper pillars 1014 and 1106 are substantially coplanar with the first major side 1214 of the package body 102.

In this embodiment, a bonding material 1302 substantially fills the cavity 1206 and the gaps between the copper pillars 1014 and 1106 and the respective TGV 1208 and 1212. The bonding material 1302 is injected into the cavity 1206 by way of the TGV 1210, for example, using injection apparatus 1304. For example, the TGV 1210 provide a pass-thru for the injection apparatus 1304 to inject the bonding material 1302 into the cavity 1206 as well as allowing air within the cavity to escape as the bonding material fills the cavity.

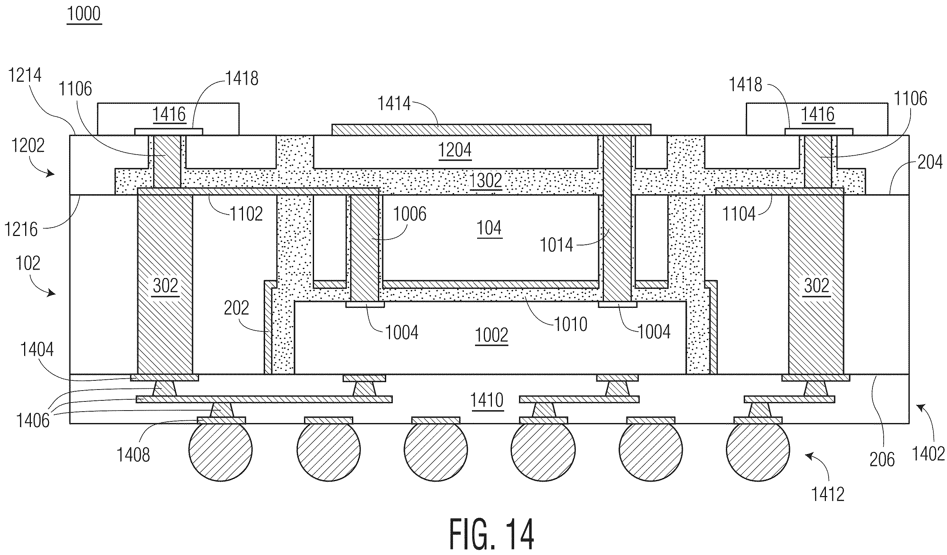

FIG. 14 illustrates, in a simplified top-side-up cross-sectional view, the example semiconductor device 1000 at a subsequent stage of manufacture in accordance with an embodiment. At this stage, an antenna 1414 and external components 1416 are attached at the top side of the semiconductor device 1000 and a redistribution structure 1402 is applied over the bottom side semiconductor device 1000. In this embodiment, the semiconductor device 1000 is separated from the carrier substrate 1008 (FIG. 13).

The redistribution structure 1402 is applied over the second major side 206 of the package body 102 and the backside of the semiconductor die 1002. In this embodiment, the redistribution structure 1402 is formed as a build-up package substrate. In some embodiments, the redistribution structure 1402 may be provided as a preformed package substrate. The redistribution structure 1402 includes conductive features (e.g., patterned copper traces and vias 1404, 1406, 1408) substantially embedded in a non-conductive substrate material (e.g., dielectric 1410). The redistribution structure 1402 includes portions of traces 1404 conductively connected to the conductive vias 302 at the second major side 206 of the package body 102 and portions of traces 1408 conductively connected to a plurality of conductive package connectors 1412 (e.g., solder balls) at the bottom side of the redistribution structure.

In this embodiment, the external components 1416 include connection pads 1416 which are connected to the redistribution traces 1102 and 1104 by way of the copper pillars 1106. For example, the semiconductor die 1002 is interconnected with the external component 1416 and the redistribution structure 1402 by way of the copper pillar 1006 and redistribution trace 1102. Each of the external components 1416 may be any of a semiconductor die, an active element (e.g., transistor, diode), a passive element (e.g., resistor, capacitor, inductor), an antenna, combinations thereof, and the like.

Generally, there is provided, a method including forming a package body comprising a glass substrate; a cavity formed at a first major side of the glass substrate, a reduced-thickness portion of the glass substrate remaining between a bottom of the cavity and a second major side of the glass substrate; a plurality of first through glass vias (TGV) formed through the reduced-thickness portion of the glass substrate; a plurality of second TGV formed through the reduced-thickness portion of the glass substrate; placing a semiconductor die onto a carrier substrate, a plurality of copper pillars formed on respective bond pads of the semiconductor die; placing the package body onto the carrier substrate such that the semiconductor die is positioned within the cavity and the plurality of copper pillars extend through respective first TGV; and injecting a bonding material, by way of the plurality of second TGV, into the cavity such that space remaining between the package body and the semiconductor die is substantially filled with the bonding material. The cavity of the package body may include a metal lining formed on sidewall and bottom surfaces. The method may further include forming a redistribution structure on the second major side of the glass substrate of the package body, the redistribution structure interconnected with the plurality of copper pillar. The glass substrate of the package body may further include a plurality of third TGV formed through a full-thickness portion of the glass substrate, each of the third TGV configured to form a conductive via, a first end of one of the conductive vias interconnected with the redistribution structure. The method may further include interconnecting an external component to a second end of the one of the conductive vias. The injecting the bonding material, by way of the plurality of second TGV, may further include substantially filling space remaining between sidewalls of the first TGV and respective copper pillars with the bonding material. The method may further include grinding a backside of the semiconductor die to substantially thin the semiconductor die. The method may further include affixing a heat sink to a backside of the semiconductor die. A backside of the semiconductor die and the first major side of the glass substrate may be substantially coplanar.

In another embodiment, there is provided, a semiconductor device including a glass substrate; a cavity formed at a first major side of the glass substrate, a reduced-thickness portion of the glass substrate remaining between a bottom of the cavity and a second major side of the glass substrate; a plurality of first through glass vias (TGV) formed through the reduced-thickness portion of the glass substrate; a plurality of second TGV formed through the reduced-thickness portion of the glass substrate; a semiconductor die having a plurality of bond pads at an active side, a plurality of copper pillars formed on respective bond pads of the plurality of bond pads, the semiconductor die positioned within the cavity such that the plurality of copper pillars extend through respective first TGV; and a bonding material disposed in the cavity, a cavity region from sidewalls and bottom surfaces of the cavity to the semiconductor die substantially filled with the bonding material. The semiconductor device may further include a metal lining formed on sidewall and bottom surfaces of the cavity. The semiconductor device may further include a redistribution structure formed on the second major side of the glass substrate, the redistribution structure interconnected with the plurality of copper pillars. The semiconductor device may further include a plurality of third TGV formed through a full-thickness portion of the glass substrate, each of the third TGV configured as a conductive via, a first end of one of the conductive vias interconnected with the redistribution structure. A second end of the one of the conductive vias may be exposed at the second major side of the glass substrate and configured for connection of an external component. The bonding material may be further disposed within the plurality of second TGV and between sidewall surfaces of the first TGV and respective copper pillars.

In yet another embodiment, there is provided, a method including forming a first cavity at a first major side of a first glass substrate, a reduced thickness portion of the first glass substrate remaining between a bottom of the first cavity and a second major side of the first glass substrate; forming a plurality of first through glass vias (TGV) through the reduced thickness portion of the first glass substrate; forming a plurality of second TGV through the reduced thickness portion of the first glass substrate; placing the first glass substrate over a semiconductor die having a plurality of copper pillars formed on respective bond pads of the semiconductor die such that the semiconductor die is positioned within the first cavity and the plurality of copper pillars extend through respective first TGV; and injecting a bonding material, by way of the plurality of second TGV, into the first cavity such that space remaining between the first glass substrate and the semiconductor die is substantially filled with the bonding material. The method may further include forming a metal lining on sidewall and bottom surfaces of the first cavity. The method may further include forming a plurality of third TGV through a full-thickness portion of the glass substrate, a metal material disposed within each of the third TGV to form a plurality of conductive vias. The method may further include forming a metal trace on the second major side of the glass substrate of the package body, the metal trace configured to interconnect a first copper pillar with a first conductive via. The method may further include forming a second cavity at a first major side of a second glass substrate, a reduced thickness portion of the second glass substrate remaining between a bottom of the second cavity and a second major side of the second glass substrate; forming a plurality of fourth TGV through the reduced thickness portion of the second glass substrate; forming a plurality of fifth TGV through the reduced thickness portion of the second glass substrate; placing the second glass substrate over the first glass substrate such that a subset of the plurality of copper pillars extend through respective first TGV and fourth TGV; and injecting a second bonding material, by way of the plurality of fifth TGV, into the second cavity such that space remaining between the second glass substrate and the first glass substrate is substantially filled with the second bonding material.

By now, it should be appreciated that there has been provided a semiconductor device with an embedded semiconductor die. The semiconductor device includes a glass substrate configured as a package body. The glass substrate includes a cavity formed at a first major side and a plurality of through-glass vias. The semiconductor die includes copper pillars formed on bond pads. The semiconductor die is embedded in the cavity and the copper pillars are inserted through the through-glass vias. A bonding material is injected into the cavity to fill gaps between the semiconductor die and inner surfaces of the cavity. A redistribution structure is applied over a second major side of the glass substrate and interconnected with the copper pillars exposed through the through-glass vias. By forming the semiconductor device with an embedded semiconductor die in this manner, a substantially rigid and low-profile semiconductor device with improved heat dissipation may be realized.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method comprising:
forming a package body comprising:
a glass substrate;
a cavity formed at a first major side of the glass substrate, a reduced-thickness portion of the glass substrate remaining between a bottom of the cavity and a second major side of the glass substrate;
a plurality of first through glass vias (TGV) formed through the reduced-thickness portion of the glass substrate;
a plurality of second TGV formed through the reduced-thickness portion of the glass substrate;
placing a semiconductor die onto a carrier substrate, a plurality of copper pillars formed on respective bond pads of the semiconductor die;
placing the package body onto the carrier substrate such that the semiconductor die is positioned within the cavity and the plurality of copper pillars extend through respective first TGV; and
injecting a bonding material, by way of the plurality of second TGV, into the cavity such that space remaining between the package body and the semiconductor die is substantially filled with the bonding material.

2. The method of claim 1, wherein the cavity of the package body includes a metal lining formed on sidewall and bottom surfaces.

3. The method of claim 1 or claim 2, further comprising forming a redistribution structure on the second major side of the glass substrate of the package body, the redistribution structure interconnected with the plurality of copper pillar.

4. The method of claim 3, wherein the glass substrate of the package body further includes a plurality of third TGV formed through a full-thickness portion of the glass substrate, each of the third TGV configured to form a conductive via, a first end of one of the conductive vias interconnected with the redistribution structure.

5. The method of claim 4, further comprising interconnecting an external component to a second end of the one of the conductive vias.

6. The method according to any preceding claim, wherein injecting the bonding material, by way of the plurality of second TGV, further includes substantially filling space remaining between sidewalls of the first TGV and respective copper pillars with the bonding material.

7. The method according to any preceding claim, further comprising grinding a backside of the semiconductor die to substantially thin the semiconductor die.

8. The method according to any preceding claim, further comprising affixing a heat sink to a backside of the semiconductor die.

9. The method according to any preceding claim, wherein a backside of the semiconductor die and the first major side of the glass substrate are substantially coplanar.

10. A semiconductor device comprising:
a glass substrate;
a cavity formed at a first major side of the glass substrate, a reduced-thickness portion of the glass substrate remaining between a bottom of the cavity and a second major side of the glass substrate;
a plurality of first through glass vias (TGV) formed through the reduced-thickness portion of the glass substrate;
a plurality of second TGV formed through the reduced-thickness portion of the glass substrate;
a semiconductor die having a plurality of bond pads at an active side, a plurality of copper pillars formed on respective bond pads of the plurality of bond pads, the semiconductor die positioned within the cavity such that the plurality of copper pillars extend through respective first TGV; and
a bonding material disposed in the cavity, a cavity region from sidewalls and bottom surfaces of the cavity to the semiconductor die substantially filled with the bonding material.

11. The semiconductor device of claim 10, further comprising a metal lining formed on sidewall and bottom surfaces of the cavity.

12. The semiconductor device of claim 10 or claim 11, further comprising a redistribution structure formed on the second major side of the glass substrate, the redistribution structure interconnected with the plurality of copper pillars.

13. The semiconductor device of claim 12, further comprising a plurality of third TGV formed through a full-thickness portion of the glass substrate, each of the third TGV configured as a conductive via, a first end of one of the conductive vias interconnected with the redistribution structure.

14. The semiconductor device of claim 13, wherein a second end of the one of the conductive vias is exposed at the second major side of the glass substrate and configured for connection of an external component.

15. The semiconductor device of any of claim 10 to claim 14, wherein the bonding material is further disposed within the plurality of second TGV and between sidewall surfaces of the first TGV and respective copper pillars.
